# DEMANDE DE BREVET EUROPEEN

(11) **EP 4 641 637 A1**
(43) Date de publication de la demande: **29.10.2025**
(21) Numéro de dépôt: 25169310.7
(22) Date de dépôt: 09.04.2025
(51) Int. Cl.: H01L 23/552, H01L 21/78, H01L 23/31, H01L 23/498, H01L 23/00, H01L 21/56, H01L 21/683

(54) **PROCÉDÉ DE FABRICATION D'UNE PUCE ÉLECTRONIQUE AYANT UN BLINDAGE ÉLECTROMAGNÉTIQUE**

(30) Priorité: 23.04.2024 FR 2404174
(71) Demandeur: STMicroelectronics International N.V., 1228 Plan-les-Ouates, Geneva (CH)
(72) Inventeur: FALLOURD, Ludovic, 37320 LOUANS (FR); CHARLEY, Sylvain, 37390 METTRAY (FR)
(74) Mandataire: Cabinet Beaumont

(57) **Abrégé**

La présente description concerne un procédé comprenant les étapes suivantes :
i) fournir une puce (100) comprenant :
- un substrat isolant (12), recouvert par une structure d'interconnexion (22), comprenant une couche isolante (24) dans laquelle sont formées des pistes conductrices (26), les pistes conductrices (26) émergeant au niveau d'une face supérieure de la structure d'interconnexion (22) et sur un des flancs de la structure d'interconnexion (22),
- des plots de connexion (30) étant partiellement enrobés par une résine (40), de manière à être connectés aux pistes conductrices (26) et à pouvoir être connecté à un élément extérieur,

ii) former un revêtement conducteur (50) pour recouvrir le substrat (12) et les flancs de la structure d'interconnexion (22), moyennant quoi le revêtement conducteur (50) est connecté aux pistes conductrices (26).

## Description

### Domaine technique

La présente description concerne le domaine des puces de type CSP (`Chip-Scale Package') ou WLCSP ('Wafer Chip Scale Package'). Elle concerne plus particulièrement un procédé de fabrication d'une puce électronique ayant un blindage électromagnétique.

### Technique antérieure

Les puces électroniques comprennent un substrat, dans ou sur lequel des circuits électroniques ont été fabriqués. Le substrat est recouvert par des plages de connexion afin de permettre un assemblage de la puce, par exemple, avec une carte de circuit imprimé.

Cependant, les puces peuvent être soumises à des interférences électromagnétiques (EMI pour 'ElectroMagnetic Interferences') qui perturbent leur fonctionnement voire peuvent causer des dommages importants, et/ou peuvent générer de telles interférences électromagnétiques.

Afin de les protéger des rayonnements électromagnétiques indésirables, il est classique de réaliser, à l'échelle du composant, un moulage autour de la puce et de former un blindage électromagnétique autour du moulage. Un deuxième moulage peut éventuellement être formé sur le blindage électromagnétique. La mise à la terre du blindage électromagnétique peut être réalisée par l'intermédiaire de vias et/ou de laminés, et peut permettre d'ajouter une antenne.

Pour fabriquer des puces électroniques, il est possible d'utiliser des céramiques cocuites à basse température (LTCC pour 'Low Temperature Cofired Ceramic') comprenant plusieurs couches diélectriques, des matériaux conducteurs (par exemple sérigraphiés) et des trous pour interconnecter les différentes couches. Le blindage est ensuite fait facilement grâce à l'utilisation de trous/vias.

Cependant, de telles puces comprennent de nombreuses couches et d'éléments d'interconnexion et sont donc complexes à fabriquer et/ou augmentent la taille de la puce finale.

### Résumé de l'invention

Il existe un besoin d'améliorer au moins en partie certains aspects des procédés connus de fabrication de puces électroniques comprenant un blindage électromagnétique.

Ce but est atteint par un procédé de fabrication d'une puce électronique ayant un blindage électromagnétique comprenant les étapes suivantes :
i) fournir une puce électronique comprenant :
   - un substrat isolant comprenant une face inférieure, une face latérale et une face supérieure,
   - une structure d'interconnexion recouvrant la face supérieure du substrat, la structure d'interconnexion comprenant une couche isolante dans laquelle sont formées des pistes conductrices, des plots de connexion étant disposés sur la structure d'interconnexion, les pistes conductrices étant disposées de manière à émerger sur au moins un des flancs de la structure d'interconnexion,
   - une résine recouvrant une face supérieure de la structure d'interconnexion et enrobant partiellement les plots de connexion de manière à pouvoir les connecter à un élément extérieur,
ii) former un revêtement conducteur sur la face latérale et sur la face inférieure du substrat ainsi que sur les flancs de la structure d'interconnexion, moyennant quoi le revêtement conducteur est connecté aux pistes conductrices au niveau d'au moins un des flancs de la structure d'interconnexion.

Selon un mode de réalisation particulier, lequel l'étape ii) est réalisée par pulvérisation d'une solution ou par jet d'encre.

Selon un mode de réalisation particulier, la solution ou l'encre contient des nanoparticules d'argent.

Selon un mode de réalisation particulier, la puce électronique fournie à l'étape i) est obtenue selon les étapes suivantes :
- fournir un substrat recouvert par la structure d'interconnexion, des plots de connexion étant disposés sur la structure d'interconnexion, les pistes conductrices étant disposées de manière à émerger sur au moins un des flancs de la structure d'interconnexion,
- déposer une résine sur les structures d'interconnexion et sur les plots de connexion,
- amincir la résine jusqu'à rendre accessible une partie des plots de connexion,
- éventuellement, amincir le substrat et/ou recouvrir la face arrière des puces par une couche de résine additionnelle,
- découper le substrat pour former différentes puces.

Ce but est également atteint par une puce électronique comprenant :
- un substrat isolant comprenant une face inférieure, une face latérale et une face supérieure,
- une structure d'interconnexion recouvrant la face supérieure du substrat, la structure d'interconnexion comprenant une couche isolante dans laquelle sont formées des pistes conductrices, des plots de connexion étant disposés sur la structure d'interconnexion, les pistes conductrices étant disposées de manière à émerger sur au moins un des flancs de la structure d'interconnexion,
- une résine recouvrant la structure d'interconnexion et laissant accessible une partie des plots de connexion,
- un revêtement conducteur recouvrant et étant en contact avec la face latérale et la face inférieure du substrat de la puce ainsi qu'avec les flancs de la structure d'interconnexion, de manière à connecter les pistes conductrices au revêtement conducteur au niveau d'au moins un des flancs de la structure d'interconnexion.

Selon un mode de réalisation particulier, l'épaisseur des pistes conductrices est comprise entre 2 et 12µm.

Selon un mode de réalisation particulier, la largeur des pistes conductrices est supérieure à 10 µm.

Selon un mode de réalisation particulier, le revêtement conducteur est en argent.

Selon un mode de réalisation particulier, les pistes conductrices, émergeant sur le flanc de la structure d'interconnexion, comportent une extrémité en forme de peigne.

Selon un mode de réalisation particulier, les pistes conductrices émergent sur deux flancs opposés de la structure d'interconnexion.

Ce but est également atteint par l'utilisation d'une telle puce électronique dans une automobile, par exemple dans un système avancé d'aide à la conduite, dans l'électronique personnelle, dans un équipement de communication, tel qu'un ordinateur, un téléphone portable ('smartphone'), un objet connecté (IoT) ou un de leurs périphériques.

Ce but est également atteint par une automobile, un équipement de communication, tel qu'un ordinateur, un téléphone portable ('smartphone'), un objet connecté (IoT) ou un de leurs périphériques comprenant une telle puce électronique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A, la figure 1B, la figure 1C, la figure 1D, la figure 1E, la figure 1F, la figure 1G, la figure 1H, la figure 1I et la figure 1J représentent des vues en coupe illustrant différentes étapes d'un procédé de fabrication d'une puce électronique ayant un blindage électromagnétique selon un mode de réalisation particulier ;

la figure 2 représente une vue en coupe d'une puce électronique ayant un blindage électromagnétique, selon un autre mode de réalisation particulier ;

la figure 3 représente une vue de dessus d'une puce électronique ayant un blindage électromagnétique, selon un autre mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

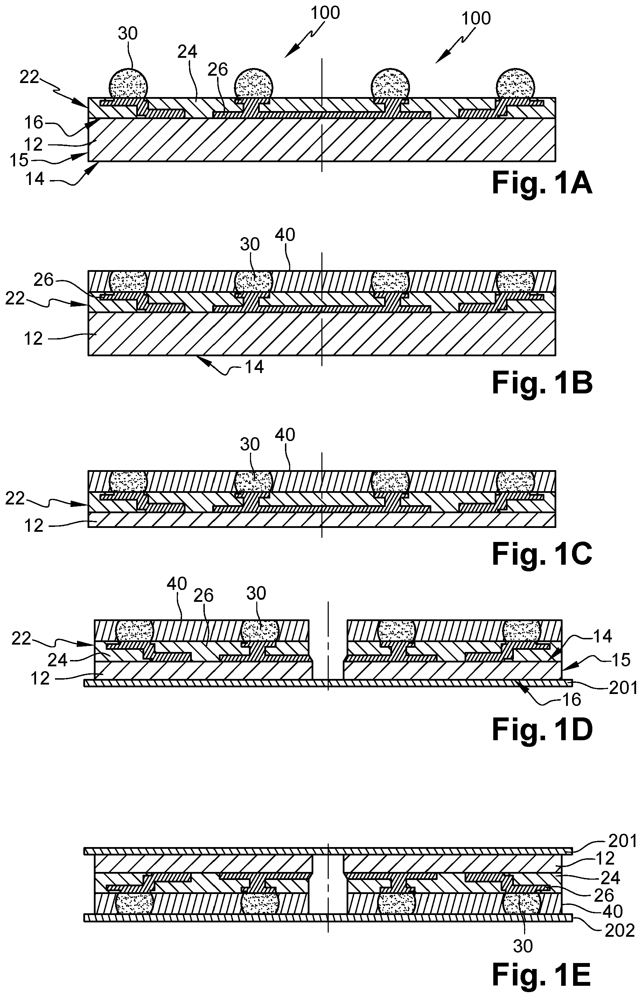

Nous allons maintenant décrire plus en détail le procédé de fabrication d'une puce électronique ayant un blindage électromagnétique en faisant référence aux figures 1A à 1J.

Le procédé comprend les étapes suivantes :
i) fournir une puce électronique 100 comprenant :
   - un substrat isolant 12 comprenant une face inférieure 14, une face latérale 15 et une face supérieure 16,
   - une structure d'interconnexion 22 recouvrant la face supérieure 16 du substrat 12, la structure d'interconnexion 22 comprenant une face supérieure, des flancs et une face inférieure en contact avec le substrat 12, la structure d'interconnexion 22 comprenant une couche isolante 24 dans laquelle sont formées des pistes conductrices 26, les pistes conductrices émergeant d'une part au niveau de la face supérieure pour former des plages de connexion et d'autre part sur un des flancs de la structure d'interconnexion 22,
   - des plots de connexion 30 étant fixés aux plages de connexion 26,
   - une résine 40 recouvrant la structure d'interconnexion 22 et laissant accessible une partie des plots de connexion 30, de manière à pouvoir les connecter à un élément extérieur,
ii) former un revêtement conducteur 50 sur la face latérale 15 et sur la face inférieure 16 du substrat 12 de la puce 100 ainsi que sur les flancs de la structure d'interconnexion 22, moyennant quoi les pistes conductrices 26 sont connectées au revêtement conducteur 50 au niveau du flanc de la structure d'interconnexion 22.

Avec un tel procédé, la mise à la terre du revêtement électromagnétique 50 est réalisée directement au niveau des pistes 26 de la structure d'interconnexion 22 de la puce 100. Ceci permet, non seulement, un gain de place puisqu'il n'y a pas besoin d'autres éléments additionnels pour relier la puce au revêtement mais, également, de laisser accessible les plots d'interconnexion 30 pour assembler ultérieurement la puce à un élément extérieur (puces ou circuits imprimés par exemple) .

Le blindage électromagnétique (EMI) est connecté à la terre *via* la structure d'interconnexion. Les pistes conductrices connectées au blindage électromagnétique sont les interconnexions de masse.

Le procédé ne nécessite pas de recouvrir les flancs du substrat 12 avec une couche de résine ni de former des vias dans le substrat 12.

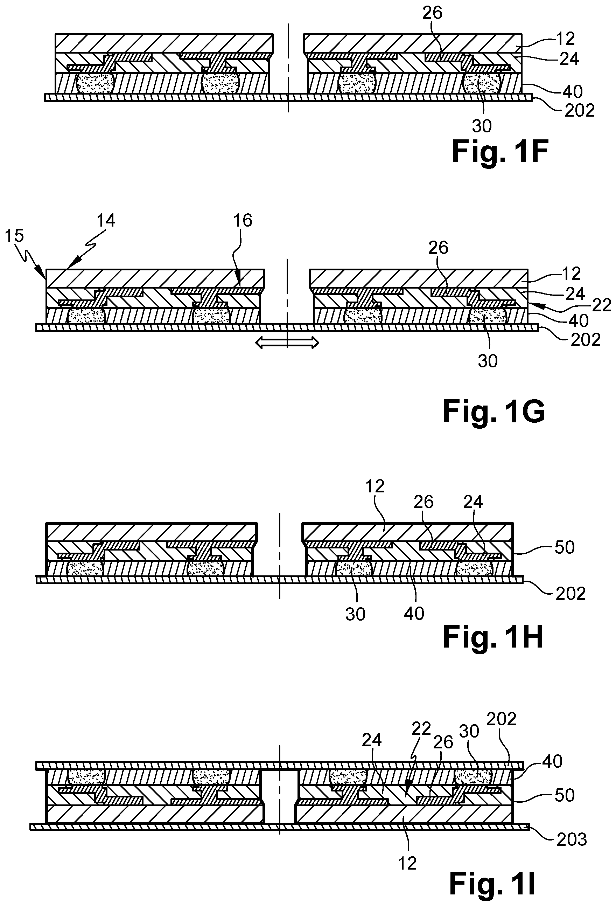

Plus particulièrement, le procédé peut comprendre les étapes suivantes :
a) fournir une structure comprenant plusieurs puces 100, la structure comprenant un substrat 12 recouvert par une structure d'interconnexion 22, des plots de connexion 30 étant fixés sur la structure d'interconnexion 22 (figure 1A),
b) déposer une résine 40 sur les structures d'interconnexion 22 et sur les plots de connexion 30 et amincir la résine 40 jusqu'à rendre accessible une partie des plots de connexion 30 (figure 1B),
c) de préférence, amincir le substrat 12 (figure 1C) et/ou recouvrir la face arrière 16 des puces 100 par une couche de résine additionnelle,
d) séparer les puces 100, en découpant la structure entre les puces, moyennant quoi on obtient des puces 100 individualisées telle que définie précédemment à l'étape i) (figure 1D), l'étape de découpe pouvant être réalisée en collant la structure obtenue à l'étape c) sur un premier adhésif 201 (ou support ('carrier')), le substrat 12 étant, de préférence, collé sur le premier adhésif 201 par sa face arrière pour réaliser l'étape de découpe depuis la face avant,
e) coller simultanément les puces 100 découpées sur un deuxième adhésif 202, les puces étant collées par leur face avant, i.e. la résine 40 et les plots de connexion 30 des puces 100 étant collés sur le deuxième adhésif 202 (figure 1E),
f) retirer le premier adhésif 201 (figure 1F),
g) si besoin, étirer le deuxième adhésif 202 de manière à rendre plus accessible la face latérale du substrat 12 et les flancs des structures d'interconnexion 22 des puces 100 (figure 1G),
h) mettre en œuvre l'étape ii), c'est-à-dire déposer le revêtement électromagnétique 50 sur la face arrière 14 et sur la face latérale 15 de la puce 100 ainsi que sur les flancs de la structure d'interconnexion 22 (figure 1H).

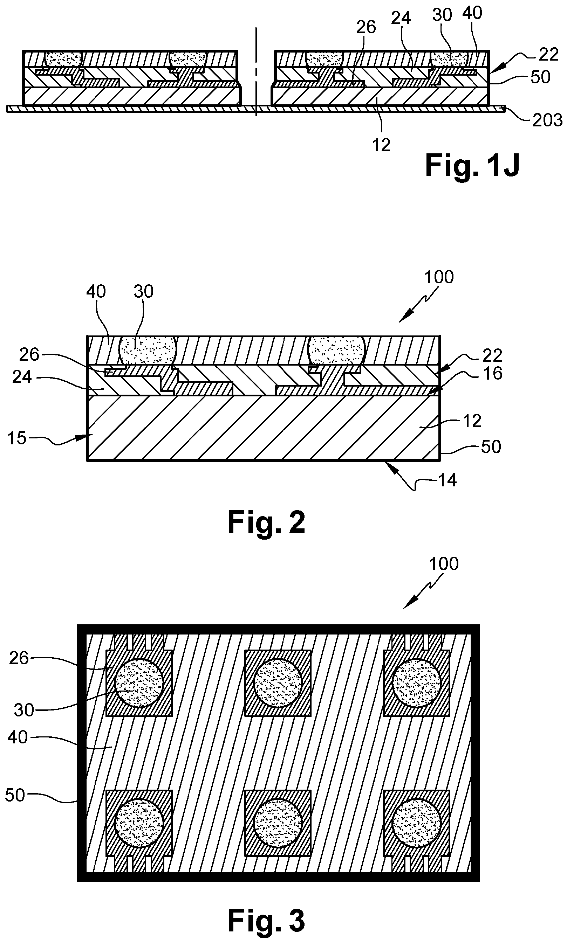

Le procédé peut, en outre, comprendre, après l'étape ii), les étapes suivantes :
- fixer les puces 100 sur un troisième adhésif 203 ('carrier'), par leur arrière, en collant le revêtement 50 sur le troisième adhésif 203 (figure 1I),
- retirer le troisième adhésif 203 (figure 1J).

Les étapes du procédé sont, de préférence, mises en œuvre pour manipuler simultanément toutes les puces provenant d'un même substrat.

A l'issue du procédé, une puce 100 comprenant un revêtement électromagnétique 50 est obtenue (figure 2 et figure 3).

Nous allons maintenant décrire plus en détail chacune des différentes étapes.

Lors de l'étape a), les parties actives des puces 100 sont formées dans un même substrat 12 et n'ont pas encore été individualisées.

Lors de l'étape a), un ou des composants discrets, non représentés, peuvent déjà avoir été formés. Le ou les composants discrets sont, par exemple, choisis parmi les transistors, diodes, thyristors, triacs, filtres, etc. La puce 100 peut comprendre un ou plusieurs circuits électroniques. La puce 100 permet de mettre en œuvre différentes fonctions électroniques.

Les puces peuvent être identiques ou différentes.

Chaque puce électronique 100 comprend :
- un substrat isolant 12,
- une structure d'interconnexion 22 recouvrant le substrat 12,
- des plots de connexion 30 disposés sur la structure d'interconnexion 22.

Selon un mode de réalisation, à ce stade de la procédure le substrat 12 correspond à une plaque.

Le substrat 12 est un substrat isolant ('high insulative substrate'). Il a, par exemple, une résistivité supérieure à 1kΩ.cm. Il s'agit, par exemple, d'un substrat résistif en silicium (HRSI pour 'High-Resistivity Silicon') ou bien en verre. Tout autre substrat à fort pouvoir isolant électriquement ou isolant électriquement peut être utilisé.

Le substrat 12 a, par exemple, une épaisseur comprise entre 100 et 900 µm, de préférence entre 300 et 900 µm, par exemple une épaisseur d'environ 725 µm.

Le substrat 12 comprend une première face 16 (face supérieure ou face avant ou encore face active) et une deuxième face 14 (face inférieure ou face arrière). Les deux faces 14 et 16 sont parallèles entre elles. Elles sont reliées entre elles par des parois latérales 15. Une couche isolante peut recouvrir la face inférieure 14.

La structure d'interconnexion 22 comprend un ou plusieurs (deux ou trois par exemple) niveaux de pistes conductrices 26, et de couches isolantes 24.

Les pistes conductrices 26 sont, par exemple, en un ou plusieurs des matériaux choisis parmi le cuivre, un alliage de cuivre, le titane, un alliage de titane, le nitrure de titane, l'or, le tungstène, le platine, et un alliage de platine. Il peut également s'agir d'aluminium. Selon un mode de réalisation, l'épaisseur de chaque piste métallique 26 est comprise entre 2 et 40 µm, par exemple entre 2 et 12 µm. Des pistes ayant des épaisseurs plus épaisses favorisent la surface de contact entre la piste 26 et le revêtement électromagnétique 50. Des pistes 26 de plus faibles épaisseurs seront plus faciles à découper.

La couche isolante 24 peut être un multicouche formé de plusieurs couches isolantes. Selon un mode de réalisation, l'épaisseur de chaque couche isolante 24 est comprise entre 0,5 µm et 15 µm.

La couche isolante 24 peut être en un matériau diélectrique, par exemple un oxyde ou un nitrure, de préférence, il s'agit d'un oxyde de silicium (SiO₂), un nitrure de silicium (par exemple du Si₃N₄). Alternativement, la couche isolante peut être en polymère, et notamment en polyimide.

La structure d'interconnexion 22 comprend une face supérieure, une face inférieure et des flancs. La face inférieure est en contact avec la face supérieure 16 du substrat 12.

Des pistes métalliques 26 affleurent au niveau de la face supérieure de manière à former des plages de connexion. Les plages de connexion (aussi appelés contacts électriques) permettent de connecter la puce 100 à d'autres éléments (puces ou circuits imprimés par exemple), au moyen des plots de connexion 30.

Les plages de connexion électriques sont aussi appelées « UBM » (pour l'expression anglo-saxonne « Under Bump Metallization »). De préférence, il y a au moins deux plages de connexion. Par exemple, sur la figure 3, six plages de connexion électrique sont visibles.

Les plages de connexion électrique sont, par exemple, à une distance de 10 à 30 µm de la paroi latérale de la puce. Cette distance dépend des puces. Elle peut aller jusqu'à plusieurs centaines de micromètres voire jusqu'au millimètre en fonction du composant réalisé.

Une partie des pistes métalliques 26 est accessible depuis les flancs des zones d'interconnexion 22 pour pouvoir être directement connectées au revêtement métallique 50, afin de réaliser une mise à la terre du revêtement 50. Les pistes métalliques sont accessibles sur au moins un flanc de la puce 100. Elles pourraient être accessibles sur plusieurs flancs de la puce 100, par exemple sur deux flancs opposés.

Des plots de connexion 30 sont fixés sur les plages de connexion. Les plots de connexion 30 sont, avantageusement, brasés sur les plages de connexion électrique. Les plots de connexion 30 sont formés en un matériau conducteur électriquement et "mouillable" (i.e. brasable ou soudable), c'est-à-dire un matériau sur lequel il est possible de réaliser un brasage. Par exemple les plots métalliques sont en un matériau brasable à base d'étain, typiquement SnAgCu ou Cu/SnAg.

Lors de l'étape b), une couche de résine 40 est déposée en face avant sur la structure d'interconnexion 22 et sur les plots de connexion 30.

La résine 40 est une résine isolante électriquement. Il peut s'agir d'une résine thermodurcissable ou une résine thermoplastique. Le matériau sera choisi de manière à ne pas être fusible sur la plage de température d'utilisation des composants électroniques. La résine peut être choisie parmi le groupe comprenant : les résines de type époxy, et les résines de type phénolique, les résines de type acrylique.

La résine peut également comprendre des particules isolantes électriquement. Les particules sont, par exemple, des particules d'oxyde, et notamment des particules d'alumine ou de silice.

La couche de résine 40 comprend une face supérieure, une face inférieure en contact avec la structure d'interconnexion 22 et une face latérale.

Après avoir été déposée, la résine 40 est amincie afin de rendre accessible la partie supérieure des plots.

Lors de l'étape c), le substrat 12 peut être aminci en face arrière 14 et/ou une couche de résine 40 peut être déposée sur l'arrière du substrat 12. Pour cela, la structure est retournée et fixée par sa face avant sur un premier support 201. Le premier support 201 est, par exemple, une bande de ruban adhésif. La structure est, ensuite, amincie par sa face arrière de façon que le substrat 12 ait son épaisseur définitive.

De préférence, les faces latérales du substrat 12 ne sont pas recouvertes par une résine.

Lors de l'étape d), le substrat 110 est découpé entre les puces 100 pour singulariser les puces. Pour cela, des tranchées, traversant de part en part la structure obtenue à l'étape c), sont formées. Les tranchées 120 définissent les contours latéraux des puces 100.

La largeur des tranchées 120 est, par exemple, comprise entre 20 et 80 µm.

Cette étape de découpe peut être réalisée au moyen d'un dispositif de découpe ou de gravure. Le dispositif de découpe est, par exemple, un outil de découpe mécanique, comme une scie. La découpe peut être réalisée avec une lame ou deux lames.

Il peut également s'agir d'une découpe laser ('laser grooving' ou 'laser dicing') ou plasma ('plasma dicing'). Ces différents procédés de découpe peuvent être aussi utilisés en commun.

La formation des tranchées peut également être réalisée par une étape de découpe par introduction de dislocation par laser (étape dite de 'stealth dicing') puis une étape d'expansion. L'étape dite de 'stealth dicing' consiste, avec un laser spécifique, à générer des dislocations au sein du substrat, dans les chemins de découpe. Ces dislocations sont des défauts présents dans l'épaisseur du substrat qui vont, sous l'effet d'une contrainte mécanique, vont permettre de séparer les puces. Il suffit alors d'étirer le support adhésif pour écarter les puces et procéder au dépôt du matériau.

Il est également possible de mettre en œuvre une première étape au cours de laquelle, un laser est utilisé pour découper la partie supérieure du dispositif allant de la face avant jusqu'à la partie inférieure de la structure d'interconnexion 22, puis une seconde étape au cours de laquelle une scie est utilisée pour découper le substrat 12. L'utilisation d'un laser pour découper les pistes (notamment en cuivre) et la couche isolante de la structure d'interconnexion permet d'obtenir une découpe nette et d'éviter les phénomènes de délamination.

L'étape de découpe est, de préférence, réalisée à partir de la face avant. Pour cela, la structure obtenue à l'étape c) est collée par sa face arrière sur un premier adhésif 201.

Une fois le substrat découpé, la structure est retournée pour pouvoir déposer le revêtement à partir de la face arrière. Pour cela, un deuxième adhésif 202 est collé sur la face avant des puces découpées (étape e)). Le deuxième adhésif 202 est un adhésif étirable.

Le premier adhésif 201 est retiré (étape f)). Puis le deuxième adhésif 202 est étiré de manière à augmenter l'écart entre deux puces 100 et rendre plus facilement accessible les flancs des puces électroniques (étape g)). Cette étape est optionnelle. Elle dépend de la largeur de la découpe faite à l'étape d) et/ou du type de procédé de dépôt de la couche de blindage 50.

Alternativement, lors de l'étape c), les puces 100 peuvent être collées sur un adhésif étirable par leur face avant. L'étape de découpe (étape c) et l'étape de dépôt du revêtement (étape h) peuvent alors être réalisées sur le même adhésif étirable. Il n'y a pas besoin de retourner les puces 100.

Les différents adhésifs utilisés dans le procédé peuvent être des adhésifs sensibles au rayonnement ultraviolet (UV) pour des applications de découpe ('UV dicing tape').

L'étape ii) est ensuite mise en œuvre.

Le revêtement peut être déposée en une fois. Autrement dit, la face arrière et la face latérale de la puce 100 sont recouvertes simultanément.

De préférence, le revêtement 50 est déposé par voie liquide. Le revêtement électromagnétique 50 est déposé, par exemple, par pulvérisation d'une solution ou par jet d'encre. Il peut également être déposé par sérigraphie. Le revêtement peut également être déposé par une technique d'évaporation ou par dépôt de couches atomiques (ALD).

La solution ou l'encre utilisée contient des nanoparticules conductrices, typiquement des nanoparticules métalliques, par exemple des nanoparticules d'argent. Alternativement aux nanoparticules, il peut également s'agir de particules ou de microparticules.

Selon le procédé mis en œuvre, le flanc 15 de la puce peut être partiellement ou totalement recouvert par le revêtement. Par exemple, le flanc de la couche de résine 40 peut être recouvert ou peut ne pas être recouvert par le revêtement 50.

A l'issue du procédé, une puce 100 telle que représentée sur les figures 2 et 3 est obtenue. La puce électronique 100 comprend :
- un substrat isolant 12 comprenant une face inférieure 14, une face latérale 15 et une face supérieure 16,
- une structure d'interconnexion 22 recouvrant la face supérieure 16 du substrat, la structure d'interconnexion 22 comprenant une face supérieure, des flancs et une face inférieure en contact avec le substrat 12, la structure d'interconnexion comprenant une couche isolante 24 dans laquelle sont formées des pistes conductrices 26, les pistes conductrices émergeant d'une part au niveau de la face supérieure de la structure d'interconnexion pour former des plages de connexion et d'autre part sur un des flancs de la structure d'interconnexion 22,
- des plots de connexion 30 étant connectés aux plages de connexion,
- une résine 40 recouvrant la structure d'interconnexion et laissant accessible une partie des plots de connexion,
- un revêtement conducteur 50 recouvrant et étant en contact avec la face latérale 15 et la face inférieure 14 du substrat de la puce 100 ainsi qu'avec les flancs de la structure d'interconnexion 22, de manière à connecter les pistes conductrices 26 au revêtement conducteur au niveau du flanc de la structure d'interconnexion 22.

Le revêtement conducteur est, par exemple, un revêtement métallique. Il peut être en argent.

Les pistes conductrices 26 émergeant sur le flanc de la structure d'interconnexion 22 peuvent comporter une extrémité en forme de peigne (figure 3) ou avoir une forme pleine, par exemple une forme de ruban.

Une même puce 100 peut comporter des pistes identiques ou différentes. Les pistes conductrices 26 peuvent être symétriques ou asymétriques.

On cherchera à maximiser la surface de contact entre les pistes métalliques 26 et le revêtement conducteur 50 pour assurer un bon contact électrique.

De préférence, les différentes pistes conductrices 26 émergent sur plusieurs flancs de la structure d'interconnexion 22. De préférence, les pistes conductrices 26 émergent sur deux flancs opposés de la structure d'interconnexion 22.

Les pistes 26 sont de préférence en cuivre ou en aluminium.

Chaque puce électronique 100 peut alors être fixée à un élément extérieur, par exemple une autre puce, un boîtier, une carte de circuit imprimé ou une autre puce électronique.

De telles puces électroniques trouvent des applications dans de nombreux domaines industriels, et en particulier, dans le domaine automobile, pour l'électronique personnelle, notamment dans le domaine des équipements de communication, ordinateurs et périphériques.

Il peut, par exemple, s'agir des dispositifs de connexions 5G ou plus généralement des dispositifs connectés.

Il peut également s'agir de système avancé d'aide à la conduite (ADAS pour 'advanced driver-assistance systems').

La puce électronique peut être utilisée dans un smartphone ou pour l'internet des objet (IoT pour 'Internet of Things'). L'appareil est, par exemple, connecté par 5G, WIFI ou bande ultra-large (UWB pour 'Ultra-Wide Band').

La puce peut également être intéressante pour d'autres domaines, comme par exemple pour le domaine industriel, notamment pour les énergies vertes.

De telles applications sont données à titre illustratif et ne sont pas limitatives.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'une puce électronique (100) de type CSP ayant un blindage électromagnétique (50) comprenant les étapes suivantes :
i) fournir une puce électronique (100) de type CSP comprenant :
- un substrat isolant (12), ayant une résistivité supérieure à 1kΩ.cm, comprenant une face inférieure (14), une face latérale (15) et une face supérieure (16), la partie active de la puce (100) étant formée dans le substrat (12),
- une structure d'interconnexion (22) recouvrant la face supérieure (16) du substrat, la structure d'interconnexion (22) comprenant une couche isolante (24) dans laquelle sont formées des pistes conductrices (26), des plots de connexion (30) étant disposés sur la structure d'interconnexion (22), les pistes conductrices (26) étant disposées de manière à émerger sur au moins un des flancs de la structure d'interconnexion (22),
- une résine (40) recouvrant une face supérieure de la structure d'interconnexion (22) et enrobant partiellement les plots de connexion (30) de manière à pouvoir les connecter à un élément extérieur,
ii) former un revêtement conducteur (50) sur la face latérale (15) et sur la face inférieure (14) du substrat (12) ainsi que sur les flancs de la structure d'interconnexion (22), le revêtement conducteur (50) recouvrant et étant en contact avec la face latérale (15) et la face inférieure (16) du substrat (12) de la puce (100) ainsi qu'avec les flancs de la structure d'interconnexion (22), moyennant quoi le revêtement conducteur (50) est connecté aux pistes conductrices (26) au niveau d'au moins un des flancs de la structure d'interconnexion (22).

2. Procédé selon la revendication 1, dans lequel l'étape ii) est réalisée par pulvérisation d'une solution ou par jet d'encre.

3. Procédé selon la revendication 2, dans lequel la solution ou l'encre contient des nanoparticules d'argent.

4. Procédé selon l'une quelconque des revendications précédentes, dans lequel la puce électronique (100) fournie à l'étape i) est obtenue selon les étapes suivantes :
- fournir un substrat (12) recouvert par la structure d'interconnexion (22), les plots de connexion (30) étant disposés sur la structure d'interconnexion (22), les pistes conductrices (26) étant disposées de manière à émerger sur au moins un des flancs de la structure d'interconnexion (22),
- déposer une résine (40) sur les structures d'interconnexion (22) et sur les plots de connexion (30),
- amincir la résine (40) jusqu'à rendre accessible une partie des plots de connexion (40),
- éventuellement, amincir le substrat (12) et/ou recouvrir la face inférieure (14) du substrat (12) par une couche de résine additionnelle,
- découper le substrat (12) pour former différentes puces (100).

5. Puce électronique (100) de type CSP ayant un blindage électromagnétique (50) comprenant :
- un substrat isolant (12) ayant une résistivité supérieure à 1kΩ.cm et comprenant une face inférieure (14), une face latérale (15) et une face supérieure (16), la partie active de la puce (100) étant formée dans le substrat (12),
- une structure d'interconnexion (22) recouvrant la face supérieure (16) du substrat, la structure d'interconnexion (22) comprenant une couche isolante (24) dans laquelle sont formées des pistes conductrices (26), des plots de connexion (30) étant disposés sur la structure d'interconnexion (22), les pistes conductrices (26) étant disposées de manière à émerger sur au moins un des flancs de la structure d'interconnexion (22),
- une résine (40) recouvrant la structure d'interconnexion (22) et laissant accessible une partie des plots de connexion (30),
- un revêtement conducteur (50) recouvrant et étant en contact avec la face latérale (15) et la face inférieure (16) du substrat (12) de la puce (100) ainsi qu'avec les flancs de la structure d'interconnexion (22), de manière à connecter les pistes conductrices (26) au revêtement conducteur (50) au niveau d'au moins un des flancs de la structure d'interconnexion (22).

6. Puce selon la revendication précédente, dans lequel l'épaisseur des pistes conductrices (26) est comprise entre 2 et 12µm.

7. Puce selon l'une des revendications 5 et 6, dans laquelle la largeur des pistes conductrices (26) est supérieure à 10 µm.

8. Puce selon l'une des revendications 5 à 7, dans laquelle le revêtement conducteur (50) est en argent.

9. Puce selon l'une quelconque des revendications 5 à 8, dans laquelle les pistes conductrices (26), émergeant sur le flanc de la structure d'interconnexion (22), comportent une extrémité en forme de peigne.

10. Puce selon l'une quelconque des revendications 5 à 9, dans laquelle les pistes conductrices (22) émergent sur deux flancs opposés de la structure d'interconnexion (22).
